(19) Europäisches Patentamt
European Patent Office
Office européen des brevets

(11) **EP 3 300 205 A1**

(12) **EUROPEAN PATENT APPLICATION**
published in accordance with Art. 153(4) EPC

(43) Date of publication:
**28.03.2018 Bulletin 2018/13**

(51) Int Cl.:
***H02J 3/00*** (2006.01)

(21) Application number: **16796313.1**

(22) Date of filing: **09.05.2016**

(86) International application number:
**PCT/JP2016/063696**

(87) International publication number:
**WO 2016/185919 (24.11.2016 Gazette 2016/47)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **21.05.2015 JP 2015104036**
**27.10.2015 JP 2015211260**

(71) Applicant: **Hitachi, Ltd.**
**Tokyo 100-8280 (JP)**

(72) Inventors:
• **UTSUMI, Masato**
**Tokyo 100-8280 (JP)**
• **WATANABE, Tohru**
**Tokyo 100-8280 (JP)**
• **IKEMOTO, Yu**
**Tokyo 100-8280 (JP)**
• **SAKIKUBO, Youko**
**Tokyo 100-8280 (JP)**
• **SHIGEMORI, Ikuo**
**Tokyo 100-8280 (JP)**
• **OGAWA, Hiroaki**
**Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(54) **ENERGY DEMAND PREDICTING SYSTEM AND ENERGY DEMAND PREDICTING METHOD**

(57) [Problem] To predict demand under circumstances in which continuous total contracted demand characteristics vary within a short time period.

[Solution] This energy demand predicting method is configured in such a way that: sets of demand pattern generation data for each of one or more preset combinations of a contracted demand granularity and a time granularity are generated on the basis of actual energy demand information for a default historical period; a demand type is generated for each set of demand pattern generation data; an energy demand at a default historical date and time is calculated as a predicted value for evaluation, for each demand type; a contracted demand granularity and a time granularity are determined on the basis of the predicted value for evaluation for each demand type and the actual energy demand information, in such a way as to minimize an error between an estimated value or a predicted value of energy demand at a historical date and time, and the actual observed value at said date and time; and the energy demand value at an arbitrarily defined date and time is estimated or predicted on the basis of the determined results.

[Fig. 2]

**Description**

Technical Field

The present invention relates to an energy demand predicting system and an energy demand predicting method.

Background Art

An electric service provider, which sells electricity to a consumer based on a concluded electricity supply contract, generates electricity to be sold by an electricity generator of its own company, or procures the electricity to be sold directly from another electric service provider or through a trade spot, is generally required to cause a procurement quantity of the electricity to coincide with a sales quantity for each settlement time. Accordingly, it is important for the electric service provider to accurately predict a future value of the sum (total contracted demands) of demands (contracted demands) of consumers who have made a contract with its own company.

As a technology which predicts the above-described demands, for example, PTL 1 discloses a method for separating past chronological electric power demand data into long-period variation demand data and short-period variation demand data, calculating a demand prediction value of a short time in the future for a long-period variation demand using a transition vector method based on the long-period variation demand data, and calculating a demand prediction value of a short time in the future for a short-period variation demand using a local fuzzy-constitution method based on the short-period variation demand data. According to the method disclosed in PTL 1, it is possible to compute a total electric power demand prediction value by adding up both the demand prediction values of the short time in the future.

In addition, PTL 2 discloses a method for generating load curves by performing division into existing electric power for business, existing heat for business, newly-built electric power for business, newly-built heat for business, existing electric power for industry, existing heat for industry, newly-built electric power for industry, and newly-built heat for industry. According to the method disclosed in PTL 2, it is possible to generate the load curves from a small quantity of basic data.

Furthermore, PTL 3 discloses a method for preparing prediction data by performing classification on consumer information data based on attributes, such as a house type and a possession appliance type, randomly extracting used quantity information from a database based on a classification result, acquiring a maximum used quantity of each attribute from the extracted used quantity information, and acquiring a frequency distribution in which the maximum used quantity appears.

Citation List

Patent Literature

PTL 1: JP-A-2005-328673
PTL 2: JP-A-2006-333687
PTL 3: JP-A-07-64609

Summary of Invention

Technical Problem

Generally, electric service providers, called a Power Producer and Supplier (PPS) and a new electric power, have a relatively small scale of the number of in-force contracts, and thus continuous total contracted demand characteristics significantly change in a short time period in association with increase and reduction in the number of contracts or the like. In PTL 1, it is assumed that continuous characteristics do not significantly change in the past and the future, and thus there is a problem in that it is difficult to accurately predict future values of the total contracted demands of the contracted demands of the electric service providers in which the scale of the number of in-force contracts is small. In addition, in PTL 1, it is difficult to reflect the demand characteristics which are different from each other for respective demand types, and thus there is a problem in that an error becomes large.

In addition, in PTLs 2 and 3, the demand characteristics which are different from each other for respective demand types are reflected, and thus more accurate demand prediction is realized. However, in PTL 2, it is assumed that characteristics of demand types, such as existing and newly-built for business or for industry, do not change according to time. In addition, PTL 3 does not include a mechanism which determines the number of classifications and a granularity (in units of a day, in units of a week, and the like) of the demand type which is optimal to the prediction. That is, in those technologies, there is a problem in that it is difficult to accurately grasp the number of demand types accompanying with a change and the granularity thereof.

The present invention is made in consideration of the above-described problems, and an object of the invention is to provide an energy demand predicting system and an energy demand prediction in which it is possible to predict a demand while continuous total contracted demand characteristics change in a short time period by determining the number and granularities of demand types to be determined such that a prediction error becomes minimum.

Solution to Problem

In order to solve the above problem, in the present invention, there is provided an energy demand predicting system, which predicts an energy demand, including: a basic data extraction unit for demand pattern generation that extracts energy demand record information corresponding to a preset past period as basic data for demand pattern generation; a classification granularity adjustment processing unit that generates each of demand pattern generation data which includes one or more unit data each indicative of an energy demand for each time granularity in a combination for each of one or more preset combinations of a contracted demand granularity and the time granularity based on the extracted basic data for demand pattern generation; a segmentation processing unit that classifies the respective unit data included in the demand pattern generation data as a proper number of subsets based on a characteristic quantity indicative of a characteristic of an energy demand tendency for each demand pattern generation data, and extracts a demand pattern indicative of a representative energy consumption tendency for each subset; a profile processing unit that generates a combination of each demand pattern of the demand pattern generation data and consumer attribute information, which is common to each demand pattern, for each demand pattern generation data as a demand type of the demand pattern generation data; an evaluation prediction value computation processing unit that computes the energy demand at a preset past date and time as an evaluation prediction value for each demand type; an evaluation and calculation unit that determines the contracted demand granularity and the time granularity such that an error is minimized between an estimated value or a prediction value of the energy demand at the past date and time and an actual observed value at a relevant date and time based on the evaluation prediction value for each demand type and the energy demand record information; and a final prediction value computation processing unit that estimates or predicts an energy demand value at the relevant date and time based on information of the demand type according to the determined contracted demand granularity and the time granularity, information of an electricity sales plan at an arbitrary date and time, and a prediction value of the attribute information at the relevant date and time.

In addition, in order to solve the above problem, in the present invention, there is provided an energy demand predicting method for predicting an energy demand, the method including: a first step of extracting energy demand record information corresponding to a preset past period as basic data for demand pattern generation; a second step of generating each of demand pattern generation data which includes one or more unit data each indicative of an energy demand for each time granularity in a combination for each of one or more preset combinations of a contracted demand granularity and the time granularity based on the extracted basic data for demand pattern generation; a third step of classifying the respective unit data included in the demand pattern generation data as a proper number of subsets based on a characteristic quantity indicative of a characteristic of an energy demand tendency for each demand pattern generation data, extracting a demand pattern indicative of a representative energy consumption tendency for each subset, generating a combination of each demand pattern of the demand pattern generation data and consumer attribute information, which is common to each demand pattern as a demand type of the demand pattern generation data, and computing the energy demand at a preset past date and time as an evaluation prediction value for each demand type; a fourth step of determining the contracted demand granularity and the time granularity such that an error is minimized between an estimated value or a prediction value of the energy demand at the past date and time and an actual observed value at a relevant date and time based on the evaluation prediction value for each demand type and the energy demand record information; and a fifth step of estimating or predicting an energy demand value at the relevant date and time based on information of the demand type according to the determined contracted demand granularity and the time granularity, information of an electricity sales plan at an arbitrary date and time, and a prediction value of the attribute information at the relevant date and time.

Advantageous Effects of Invention

According to the present invention, it is possible to predict a demand while continuous total contracted demand characteristics change in a short time period.

Brief Description of Drawings

[Fig. 1] Fig. 1 is a diagram illustrating a whole configuration of an energy demand management system.
[Fig. 2] Fig. 2 is a diagram illustrating a whole configuration of an energy demand predicting system.
[Fig. 3] Fig. 3 is a diagram illustrating functions of respective devices which form the energy demand predicting system.
[Fig. 4] Fig. 4 is a conceptual diagram illustrating consumer information to be displayed.
[Fig. 5] Fig. 5 is a conceptual diagram illustrating estimated and actual sales contract information to be displayed.
[Fig. 6] Fig. 6 is a conceptual diagram illustrating demand type information to be displayed.
[Fig. 7] Fig. 7 is a conceptual diagram illustrating the demand type information to be displayed.
[Fig. 8] Fig. 8 is a conceptual diagram illustrating the demand type information to be displayed.
[Fig. 9] Fig. 9 is a conceptual diagram illustrating the demand type information to be displayed.
[Fig. 10] Fig. 10 is a flowchart illustrating a procedure of an energy demand prediction process.
[Fig. 11] Fig. 11 is a flowchart illustrating a procedure of a segmentation process.
[Fig. 12] Fig. 12 is a flowchart illustrating a procedure of an evaluation prediction value computation process.
[Fig. 13] Fig. 13 is a conceptual diagram illustrating an advantage according to a provided technology. Description of Embodiments

Embodiments of the present invention will be described in detail with reference to the accompanying drawings.

(1) First Embodiment

(1-1) Whole Configuration

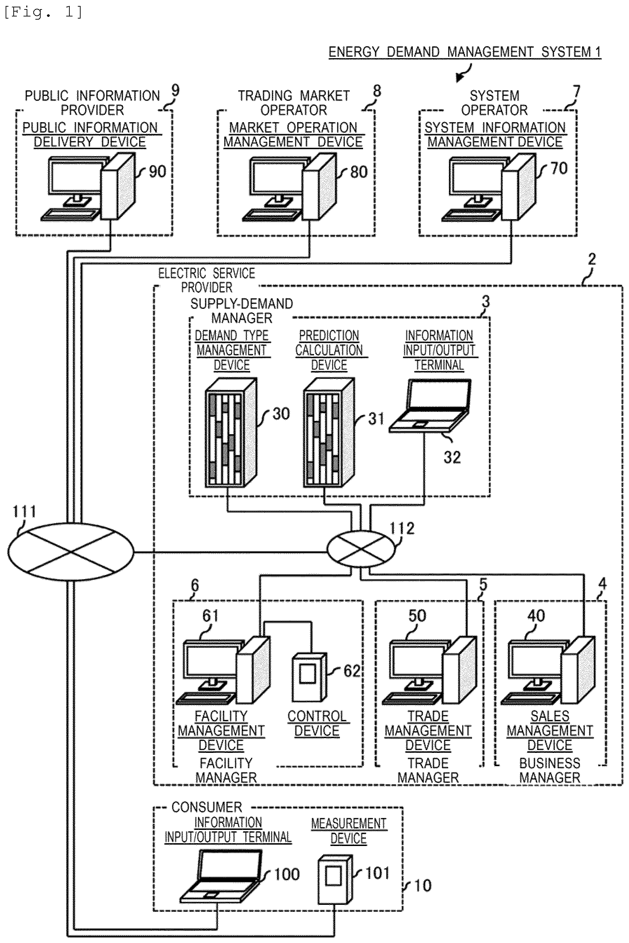

Fig. 1 illustrates a whole configuration of an energy demand management system 1 according to an embodiment. The energy demand management system 1 is a system which computes a consumption prediction value at an arbitrary date and time based on demand record information, generates and controls an operation plan of an operable electric power generator based on the computed demand prediction value, and generates and executes a trade plan directly from another electric service provider or through electric power procurement from a trade spot. The energy demand management system 1 includes various devices and various terminals which are possessed by an electric service provider 2, a system operator 7, a trading market operator 8, a public information provider 9, and a consumer 10, respectively. In addition, communication paths 111 and 112 are communication paths which communicably connect the various devices and terminals, which are included in the energy demand management system 1, to each other, and include, for example, a Local Area Network (LAN).

The electric service provider 2 is a service provider who includes a supply-demand manager 3, a business manager 4, a trade manager 5, and a facility manager 6.

For example, the supply-demand manager 3 is a department or a person in charge which predicts a future demand quantity for every settlement time unit by 30 minutes based on a sales plan and a future sales plan of its own company and manages an electric power procurement quantity such that the predicted demand quantity can be satisfied. The supply-demand manager 3 includes a prediction calculation device 31 which computes a demand prediction value, a demand type management device 30 which generates and manages a demand type used to compute the demand prediction value, and an information input/output terminal 32 which exchanges data with the devices.

The business manager 4 is a department or a person in charge which makes a long-period or short-period electricity sales plan, concludes a new electricity supply contract with a consumer, and manages an existing electricity supply contract. The business manager 4 includes a sales management device 40 which manages the made sales plan or information of the consumer who has concluded the electricity supply contract.

The trade manager 5 is a department or a person in charge which plans and executes a trade for procuring electricity through a direct contract with another electric service provider or through the trade spot. The trade manager 5 includes a trade management device 50 which manages an electricity procurement trade plan and information of a contracted electricity procurement contract and exchanges a telegram message relevant to the trade with another electric service provider or the trade spot.

The facility manager 6 is a department or a person in charge which makes and executes an operation plan of an electric power generation facility of its own company or an electric power generation facility of another company, which can be included in an electricity procurement plan of its own company. The facility manager 6 includes a facility management device 61 which manages information of the electric power generation facility, makes an operation plan of the electric power generation facility, and transmits a control signal for execution, and a control device 62 which controls the electric power generation facility in a case where the control signal is received from the facility management device 61.

In contrast, the system operator 7 is a service provider who manages an electric power transmission and distribution system facility over a wide area, measures demand records of respective regional consumers, and stores measured values. The system operator 7 includes a system information management device 70 which delivers the measured demand record values of the consumers.

In addition, the trading market operator 8 is a service provider who integrally manages information and procedures that are necessary to perform an electric power trade with respect to a plurality of electric service providers. The trading market operator 8 includes a market operation management device 80 which delivers information relevant to the electric power trade and performs a process of fixing an order received from each of the electric service providers.

The public information provider 9 is a service provider who provides past history information and future forecasting information relevant to weather, such as temperature, humidity, and solar radiation. The public information provider 9 includes a public information delivery device 90 which delivers the past history information and the forecasting information relevant to the weather.

The consumer 10 is an individual or a corporation which includes a load facility and an electric power generation facility. The consumer 10 includes an information input/output terminal 100 which transmits pieces of information, such as a possessed facility or installation, a business type, the number of people in a room, and a location, which have influence on a demand and a trendy for electric power generation, to the electric service provider 2 or the system operator 7, and a measurement device 101 which measures the demand and an electric power generation record quantity.

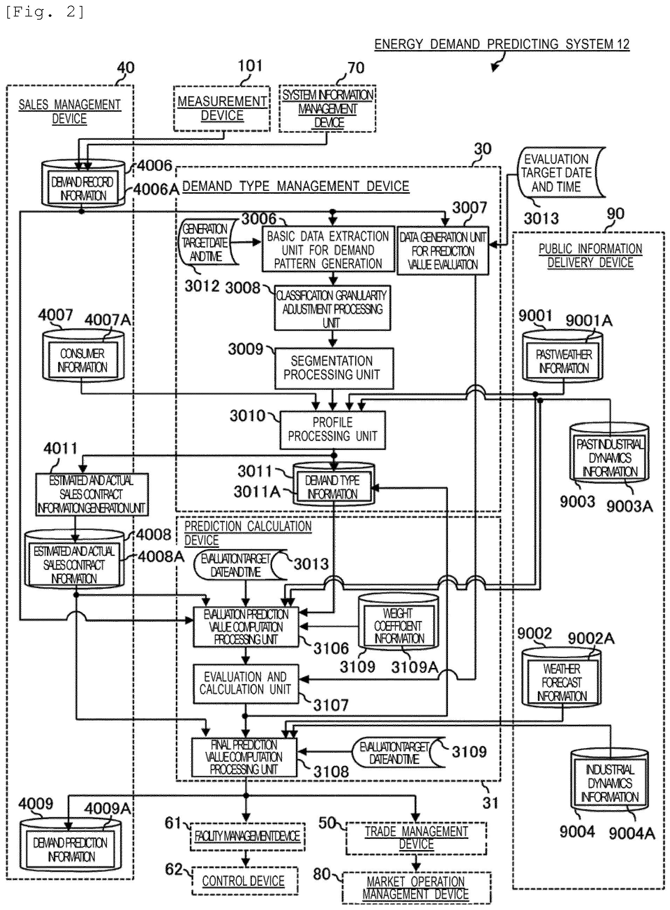

Fig. 2 illustrates an energy demand predicting system 12 according to the embodiment which forms a part of the energy demand management system 1. The energy demand predicting system 12 according to the embodiment includes the demand type management device 30, the prediction calculation device 31, and the sales management device 40.

The demand type management device 30 generates demand type information 3011 based on demand record information 4006A and consumer information 4007A which are maintained by the sales management device 40, and past weather information 9001A and past industrial dynamics information 9003A which are received from the public information delivery device 90, and transmits the generated demand type information 3011A to the prediction calculation device 31. The demand type information 3011 which is maintained by the demand type management device 30 includes, for example, an identifier (hereinafter, referred to as a demand type ID) which identifies a demand type for each consumer, attribute information which explains each demand type, and demand pattern information for each demand type.

The prediction calculation device 31 computes a demand at a preset arbitrary past date and time as an evaluation prediction value based on the demand type information 3011 which is generated by the demand type management device 30, estimated and actual sales contract information 4008 which is maintained by the sales management device 40, and the past weather information 9001A and past industrial dynamics information 9003A which are maintained by the public information delivery device 90.

In addition, the prediction calculation device 31 extracts one set of demand type information 3011 in which a difference between the evaluation prediction value and a past observed value becomes minimum, computes a demand prediction value at a designated future date and time based on the extracted demand type information, weather forecast information 9002A, and industrial dynamics information 9004A, and generates demand prediction information 4009A which is maintained by the sales management device 40. In addition, the prediction calculation device 31 transmits the demand prediction value, which is computed as described above, to the facility management device 61 and the trade management device 50.

The sales management device 40 maintains the demand record information 4006A, the consumer information 4007A, estimated and actual sales contract information 4008A, and the demand prediction information 4009A.

The demand record information 4006A among the above pieces of information is information which is generated based on pieces of past demand record information 4006A of a contracted consumer and a contract conclusion target consumer, which are acquired from the measurement device 101 and the system information management device 70. For example, the demand record information 4006A includes record values of electricity demands (energy demands) corresponding to the past few years for every 30 minutes for consumers 10.

In addition, the consumer information 4007A is information which is supplied from the consumer 10 in a case where electricity supply contract conclusion is applied from the consumer 10, and includes, for example, information indicative of attributes, such as a location, a business type, a building category, a floor area, a management company, the number of people in a room, a contracted electric power capacity, an electricity supply start date and time, and an electricity supply end date and time, of the consumer.

The estimated and actual sales contract information 4008 is information which is prepared by the sales management device 40 or the business manager 4, and includes, for example, information such as planned values and record values of an electric power capacity and the number of houses of an acquired contract for each demand type in units of a week or in units of a month over an arbitrary period in the past and future.

Furthermore, the demand prediction information 4009A is information which is generated by the prediction calculation device 31, and includes, for example, information of the demand prediction value in which a time unit granularity ranges from a 30-minute unit to a year unit, a time area ranges from next a few hours to next a few years, and a target granularity ranges from one contracted demand unit to a total contracted demand unit.

(1-2) Internal Configuration

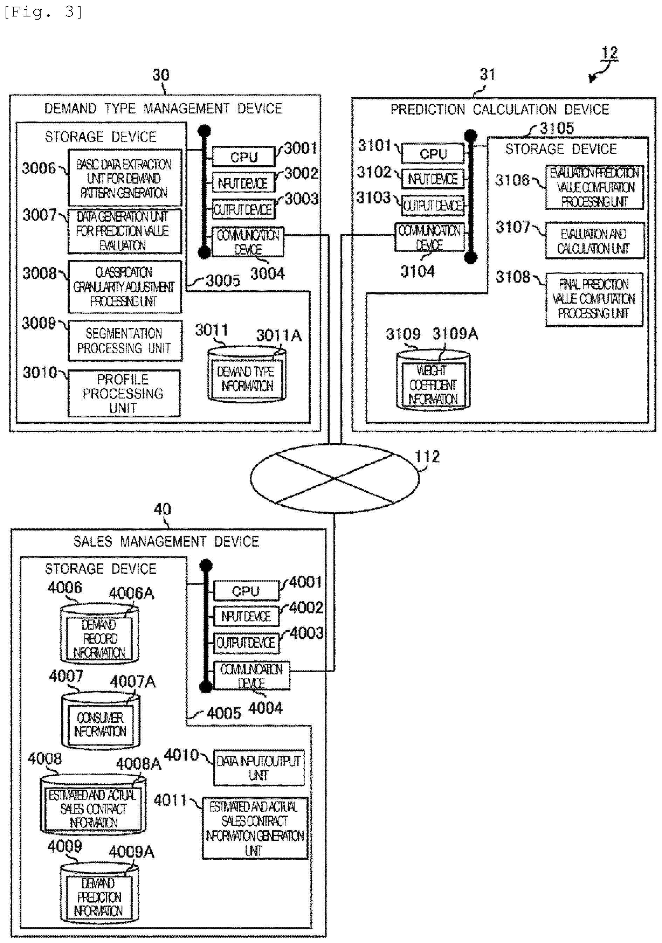

Fig. 3 illustrates a detailed configuration of respective devices which form the energy demand predicting system 12.

The demand type management device 30 includes, for example, an information processing device such as a personal computer, a server computer, or a hand-held computer, and includes a Central Processing Unit (CPU) 3001 which integrally controls an operation of the demand type management device 30, an input device 3002, an output device 3003, a communication device 3004, and a storage device 3005.

The input device 3002 includes a keyboard or a mouse, and the output device 3003 includes a display or a printer. In addition, the communication device 3004 includes a Network Interface Card (NIC) which connects a wireless LAN or a wired LAN. Furthermore, the storage device 3005 includes a storage medium such as a Random Access Memory (RAM) or a Read Only Memory (ROM).

The storage device 3005 stores various computer programs such as a basic data extraction unit 3006 for demand pattern generation, a data generation unit 3007 for prediction value evaluation, a classification granularity adjustment processing unit 3008, a segmentation processing unit 3009, and a profile processing unit 3010.

The basic data extraction unit 3006 for demand pattern generation is a program which has a function of extracting record information (hereinafter, referred to as basic data for demand pattern generation) of one or more preset contracted demands during a preset past period from the demand record information 4006A (Fig. 2).

In addition, the data generation unit 3007 for prediction value evaluation is a program which has a function of generating evaluation data in order to calculate a difference from the evaluation prediction value, which is generated by the prediction calculation device 31, from the demand record information 4006A.

The classification granularity adjustment processing unit 3008 is a program which has a function of generating one or more data sets in order to generate demand patterns according to information of one or more preset combinations of the contracted demand (consumer unit) granularity and a time granularity based on the basic data for demand pattern generation, which is extracted by the basic data extraction unit 3006 for demand pattern generation.

Meanwhile, the "contracted demand granularity" indicates, for example, a specific contracted demand unit such as one contracted demand unit, a total contracted demand unit, or an arbitrary contracted demand unit between the one contracted demand unit and the total contracted demand unit. In addition, the "time granularity" indicates a specific time unit such as units of a few hours, units of one day, units of a few days, units of one week, units of one month, or units of one year. Hereinafter, one contracted demand granularity and one time granularity are respectively set, and generated data used to generate the demand patterns is referred to as one data set or data for demand pattern generation.

The segmentation processing unit 3009 is a program which has a function of performing classification on contracted demands, in which tendencies of periodical variations in electric power consumption are similar among the respective data sets, based on the respective data sets which are generated by the classification granularity adjustment processing unit 3008, and generating representative demand patterns from the respective data sets.

The profile processing unit 3010 is a program which has a function of extracting attribute information which is common to the respective demand patterns based on the demand patterns which are generated by the segmentation processing unit 3009 and the attribute information which may be a factor that generates the demand patterns, such as the consumer information 4007A, the past weather information 9001A, and the past industrial dynamics information 9003A, and generating the demand types.

In addition, the storage device 3005 stores a database such as a demand type information storage unit 3011. The demand type information storage unit 3011 maintains the demand type information 3011A. The demand type information 3011A is information of the demand types which are generated by the profile processing unit 3010, and includes information relevant to demand type identifiers (demand type IDs) for the respective contracted demands, common attribute information of the respective demand types, and respective demand patterns of the demand types.

In contrast, the prediction calculation device 31 includes, for example, an information processing device such as a personal computer, a server computer, or a hand-held computer, and includes a CPU 3101 which integrally controls an operation of the prediction calculation device 31, an input device 3102, an output device 3103, a communication device 3104, and a storage device 3105.

The storage device 3105 includes a storage medium, such as a RAM or a ROM, and stores various computer programs, such as an evaluation prediction value computation processing unit 3106, an evaluation and calculation unit 3107, and a final prediction value computation processing unit 3108, and a preset weight coefficient 3109.

The evaluation prediction value computation processing unit 3106 is a program which has a function of computing demands at a preset past evaluation target date and time as the evaluation prediction values based on information relevant to one or more demand types which are generated by the demand type management device 30, information of the attribute information, such as the estimated and actual sales contract information 4008A, the past weather information 9001A, and the past industrial dynamics information 9003A, which are common to the respective demand types, the demand record information 4006A, and preset weight coefficient information 3109A which is managed by the sales management device 40.

In addition, the evaluation and calculation unit 3107 is a program which has a function of comparing the respective evaluation prediction values, which are computed by the evaluation prediction value computation processing unit 3106, with the evaluation data which is generated by the demand type management device 30, and extracting a demand type set in which a difference between the evaluation prediction values and the evaluation data becomes minimum. The demand type set will be described in detail later.

Furthermore, the final prediction value computation processing unit 3108 is a program which has a function of computing a demand prediction value at an arbitrary preset future date and time based on the demand type set, which is extracted by the evaluation and calculation unit 3107, and information, such as the estimated and actual sales contract information 4008A, the weather forecast information 9002A, or the industrial dynamics information 9004A, which includes a future prediction value, a forecast value, and an expected value of the attribute information which is common to the respective demand types.

Furthermore, the weight coefficient information 3109A is information which includes various weight coefficients that are used in a case where the evaluation prediction value computation processing unit 3106 computes the demands at the preset past evaluation target date and time as the evaluation prediction value as the evaluation prediction value, described above. The weight coefficient information 3109A will be described in detail later.

In contrast, the sales management device 40 includes, for example, an information processing device, such as a personal computer, a server computer, or a hand-held computer, and includes a CPU 4001 which integrally controls an operation of the sales management device 40, an input device 4002, an output device 4003, a communication device 4004, and a storage device 4005.

The input device 4002 includes a keyboard or a mouse, and the output device 4003 includes a display or a printer. In addition, the communication device 4004 includes the NIC which connects a wireless LAN or a wired LAN.

The storage device 4005 includes a storage medium, such as a RAM or a ROM, and stores various computer programs, such as a data input/output unit 4010 and an estimated and actual sales contract information generation unit 4011.

The data input/output unit 4010 is a program which has a function of performing operations of registration, search, update, and removal with respect to a database such as a demand record information storage unit 4006, a consumer information storage unit 4007, an estimated and actual sales contract information storage unit 4008, and a demand prediction information storage unit 4009.

In addition, the estimated and actual sales contract information generation unit 4011 is a program which has a function of preparing the estimated and actual sales contract information 4008A based on the demand type information 3011A which is generated by the demand type management device 30 and the consumer information 4007A which is maintained by the sales management device 40.

In addition, the storage device 4005 also stores a database such as the demand record information storage unit 4006, the consumer information storage unit 4007, an estimated and actual sales contract information storage unit 4008, or a demand prediction information storage unit 4009.

The demand record information storage unit 4006 is a database which stores information that is received and acquired from the measurement device 101 and the system information management device 70, and stores various pieces of information which include demand record information of the contracted demands and the contract target demands corresponding to past several years. A record information granularity corresponds to, for example, a 30-minute unit.

The consumer information storage unit 4007 is a database which stores information acquired based on application from the consumer 10 in a case where electricity supply contract is applied and is concluded, and stores various pieces of information which includes attributes of the consumer 10, such as a location of the consumer 10, a business type, a building category, a floor area, a management company, and the number of people in a room.

The estimated and actual sales contract information storage unit 4008 is a database which stores schedule and record information of the electricity sales plan generated by the estimated and actual sales contract information generation unit 4011 and the business manager 4, and stores various pieces of information which include planned values and actual measurement values of the number of contracts and the contracted electric power capacity for each demand type over the past and future periods.

Furthermore, the demand prediction information storage unit 4009 is a database which stores future demand prediction value information generated by the prediction calculation device 31, and stores various pieces of information which include demand prediction value for every 30 minutes from the preset start date and time to the end date and time.

(1-3) Details of Respective Configurations

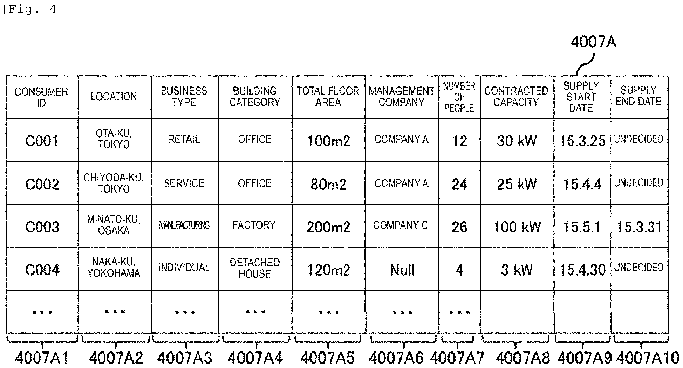

Fig. 4 is a conceptual diagram illustrating the consumer information 4007A. The consumer information 4007A is information which is prepared by the business manager 4 based on application information from the consumer 10 in a case where electricity supply contract conclusion is applied from the consumer 10 (Fig. 1) or is concluded. The consumer information 4007A is used in a case where the profile processing unit 3010 generates the demand type information.

Specifically, the consumer information 4007A has a table format which includes a consumer ID field 4007A1, a location field 4007A2, a business type field 4007A3, a building category field 4007A4, a total floor area field 4007A5, a management company field 4007A6, a people number field 4007A7, a contracted capacity field 4007A8, a supply start date field 4007A9, and a supply end date field 4007A10.

Furthermore, the consumer ID field 4007A1 stores a unique identifier (consumer ID) of the consumer 10, which is given to each consumer 10, the location field 4007A2 and the business type field 4007A3 respectively store the location and the business type of the relevant consumer 10. In addition, the building category field 4007A4, the floor area field 4007A5 field, the management company field 4007A6, and the people number field 4007A7 respectively store a building type of the relevant consumer 10, a floor area, a facility management company, the normal number of people in a room. The contracted capacity field 4007A8, the supply start date field 4007A9, and the supply end date field 4007A10 respectively store the contracted electric power capacity of the relevant consumer 10, electricity supply start date and electricity supply end date.

Accordingly, Fig. 4 illustrates that, for example, a consumer having a consumer ID "C001" has a location "Ota-ku, Tokyo", a business type "retail", a building type "office", a floor area "100 m$^2$", a facility operation management company "company A", a normal number of people in a room "12 people", a contracted electric power capacity "30 kW", a supply start date "March 25, 2015", and supply end date "undecided".

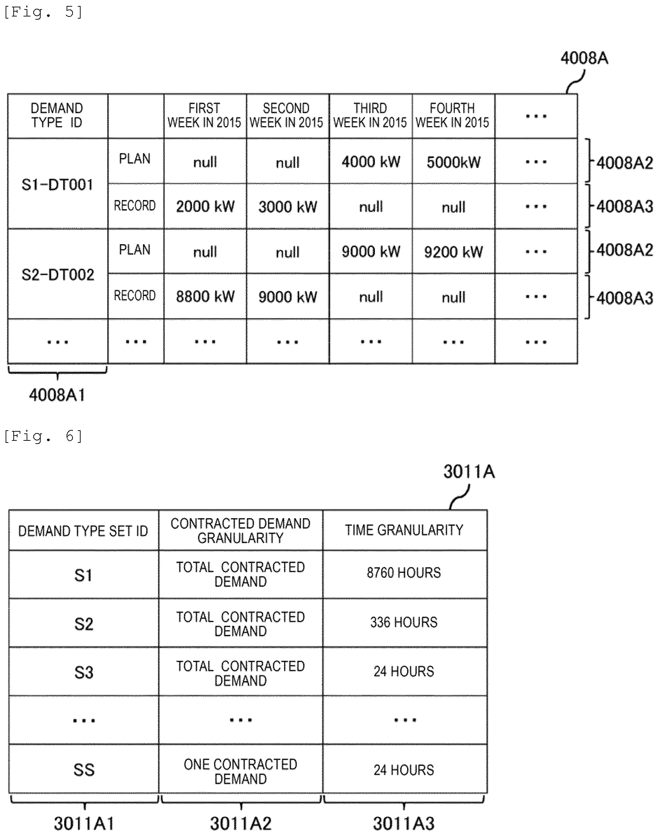

In contrast, Fig. 5 is a conceptual diagram illustrating the estimated and actual sales contract information 4008A. The estimated and actual sales contract information 4008A is information which is prepared by the sales management device 40 or the business manager 4 based on the demand type information generated by the demand type management device 30 and the consumer information 4007A, and includes planned values and record values of the electric power capacity and the number of houses of the acquired contract for each demand type for each prescribed period.

Specifically, as illustrated in Fig. 5, the estimated and actual sales contract information 4008A has a table format which includes a demand type ID field 4008A1, a planned value field 4008A2 and a record value field 4008A3 of a contract for each demand type for each period which is preset by the business manager 4, the planned value field 4008A2 and the record value field 4008A3 being respectively provided to correspond to each demand type ID field 4008A1. The granularity and an area of the period illustrated in 4008A2 are preset by the business manager 4.

Furthermore, the demand type ID field 4008A1 stores identifiers which are given to the respective demand types which will be described later and which are unique to the demand types. The planned value field 4008A2 of each demand type contract for each period stores a planned value of the contracted electric power capacity which is planned for the demand type of the corresponding period. In addition, the record value field 4008A3 of each demand type contract for each period stores a record value of the contracted electric power capacity for the relevant demand type of a relevant period.

Accordingly, Fig. 5 illustrates that, for example, record value of a contracted electric power capacity of a demand type "S1-DT001" includes "2000 kW" in a first week of 2015 and "3000 kW" in a second week, and records after the second week are not collected ("null") because the weeks subsequent to the second week are future periods. In addition, Fig. 5 illustrates that planned values of the contracted electric power capacity of the demand type are set to "4000 KW" in a third week of 2015 and "5000 kW" in a fourth week of 2015 by the business manager 4.

In contrast, Figs. 6 to 9 are conceptual diagrams illustrating the demand type information 3011A. The demand type information 3011A is information generated by the supply-demand manager 3 and the profile processing unit 3010, and includes pieces of information described below.

Fig. 6 is a conceptual diagram illustrating one demand type information 3011A which is preset by the supply-demand manager 3. The demand type information 3011A is information which includes the contracted demand granularity and the time granularity of a demand type to be generated.

Specifically, the demand type information 3011A has a table format which includes a demand type set ID field 3011A1, a contracted demand granularity field 3011A2, and a time granularity field 3011A3.

Furthermore, the contracted demand granularity field 3011A2 stores a contracted demand granularity, and the time granularity field 3011A3 stores a time granularity. In addition, the demand type set ID field stores an identifier (demand type set ID) which is unique to a demand type set given to a combination (hereinafter, referred to as the demand type set) of the contracted demand granularity stored in the relevant contracted demand granularity field 3011A2 and the relevant time granularity stored in the time granularity field 3011A3.

Accordingly, Fig. 6 illustrates that, for example, a demand type set "S1" is a combination of a contracted demand granularity "total contracted demand unit" and a time granularity "8760 hours" corresponding to one year.

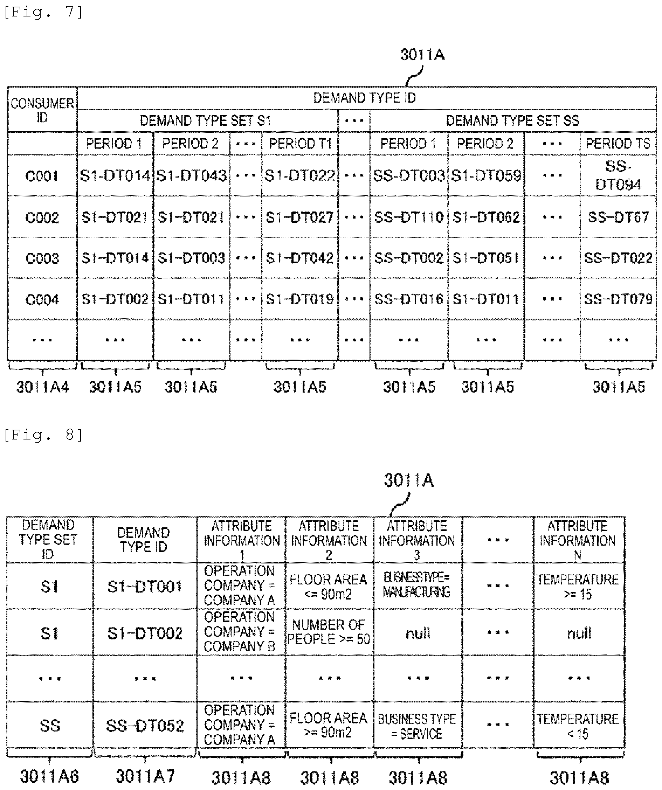

Fig. 7 is a conceptual diagram illustrating one of the demand type information 3011A generated by the profile processing unit 3010. The demand type information 3011A is information which includes a relationship between the consumer 10 and the demand type.

Specifically, the demand type information 3011A has a table format which includes a consumer ID field 3011A4, and a plurality of demand type ID fields 3011A5 which are provided plural for each demand type set.

Furthermore, the consumer ID field 3011A4 stores a consumer ID which is given to each consumer 10, and the respective demand type ID fields 3011A5 store identifiers (demand type IDs) indicative of demand types of relevant periods in a relevant demand type set of each relevant consumer 10.

Accordingly, Fig. 7 illustrates that, for example, in a case where the demand type set is "S1", the consumer 10 "C001" has a demand type "S1-DT014" in a first period, a demand type "S1-DT043" in a second period, and a demand type "S1-DT022" in a last period "T1". In addition, Fig. 7 illustrates that, in a case where the demand type set is "SS", the consumer 10 has different demand types in the period 1, the period 2, and the last period "TS" from the case where the demand type set is "S1".

Meanwhile, the number of periods up to the last period "T1 in the case where the demand type set is "S1" is not necessarily the same as the number of institutions up to the last period "TS" in a case where the demand type set is "S2", and each number of periods is determined based on the time granularity field 3011A3 of the demand type information 3011A with respect to a period of the basic data for demand pattern generation, which is extracted by the basic data extraction unit 3006 for demand pattern generation.

Fig. 8 is a conceptual diagram illustrating one of the demand type information 3011A generated by the profile processing unit 3010. The demand type information 3011A is information which includes a common attribute which common to the respective demand types.

Specifically, the demand type information 3011A has a table format which includes a demand type set ID field 3011A6, a demand type ID field 3011A7, and a plurality of attribute information fields 3011A8.

Furthermore, the demand type set ID field 3011A6 stores demand type set IDs which are respectively given to the respective demand type sets, and the demand type ID field 3011A7 stores a demand type ID of one demand type generated from a relevant demand type set. Therefore, the demand type information 3011A is provided with rows corresponding to the same number as the number of demand types, which can be generated from the demand type set, with respect to one demand type set ID, and the demand type ID fields 3011A7 in the respective rows store the demand type IDs of different demand types, respectively.

In addition, the respective attribute information fields 3011A8 respectively store content of the pieces of attribute information which are common to the contracted demand that belongs to the relevant demand type generated from the relevant demand type set.

Accordingly, Fig. 8 illustrates that, for example, N pieces of attribute information, such as an operating company "company A", a floor area "90 m$^2$ or larger", a business type "manufacturing", and a temperature "15°C or lower", are extracted with respect to a demand type "S1-DT001", which is generated from the demand type set "S1", as the pieces of attribute information which are common to the contracted demand that belongs to the demand type. In addition, Fig. 8 illustrates that only two pieces of attribute information, such as an operating company "company B" and the number of people "50 or more", are extracted with respect to a demand type "S1-DT002" which is generated from the demand type set "S1". In this case, since it is possible to explain difference from another demand type, the pieces of attribute information subsequent to the third attribute information are set to "null". Meanwhile, in a case where the attribute information is not sufficient, "null" is set in the same manner.

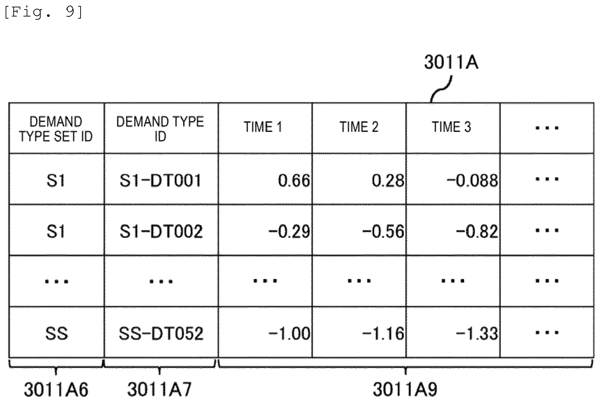

Fig. 9 is a conceptual diagram illustrating one of the demand type information 3011A generated by the profile processing unit 3010. The demand type information 3011A includes representative demand patterns of the respective demand types.

Specifically, the demand type information 3011A has a table format which includes a demand type set ID field 3011A6, a demand type ID field 3011A7, and a plurality of time fields 3011A9.

Furthermore, the demand type set ID field 3011A6 stores demand type set IDs which are respectively given to the respective demand type sets, and the demand type ID field 3011A7 stores a demand type ID corresponding to one demand type generated from the relevant demand type set. Therefore, the demand type information 3011A is provided with rows corresponding to the same number as the number of demand types, which can be generated from the demand type set, with respect to one demand type set ID, and the demand type ID fields 3011A7 in the respective rows store the demand type IDs of different demand types, respectively.

In addition, each of the time fields 3011A9 stores a value which indicates a representative demand pattern in relevant time of the relevant demand type of the relevant demand type set.

Accordingly, Fig. 9 illustrates that, for example, a demand type "S1-DT001" of the demand type set "S1" corresponds to a demand pattern in which time 1 "0.66", time 2 "0.28", and time 3 "-0.088" are connected in chronological order.

Meanwhile, here, the time means, for example, a 30-minute unit. In addition, the demand pattern illustrated in Fig. 9 indicates a demand pattern which is acquired as a result through normalization of original data such that an average is 0 and a standard deviation is 1 at a point of time in which a data generation process is performed in the classification granularity adjustment processing unit 3008, and the process may proceed without performing a normalization process in the classification granularity adjustment processing unit 3008. In this case, a unit of the data pattern value illustrated in Fig. 9 is the same as a unit of data recorded in the demand record information 4006A.

(1-4) Energy Demand Prediction Process

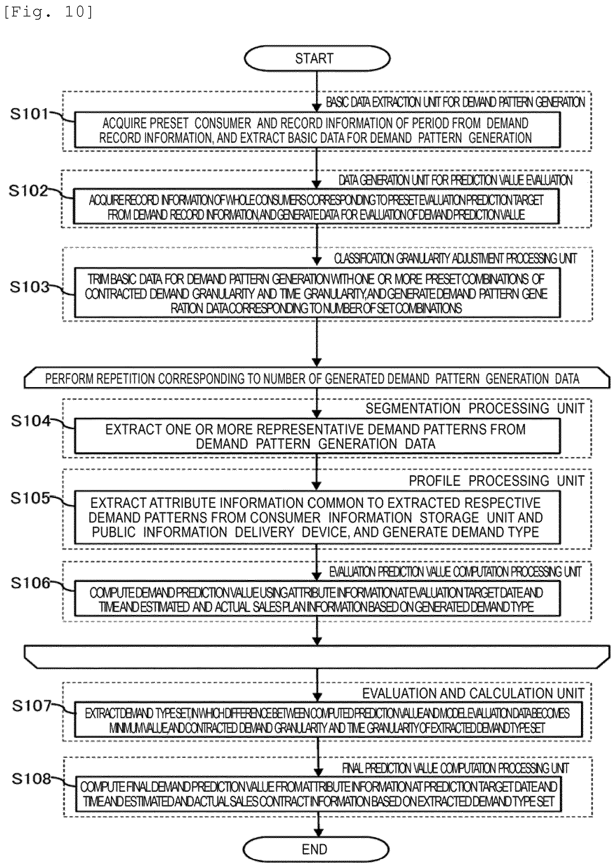

Fig. 10 illustrates a process procedure of an energy demand prediction process. The process is a process which starts in a case where the demand type management device 30 receives an input operation from the supply-demand manager 3. Processes from step S101 to step S105 are executed by the demand type management device 30 and processes from step S106 to step S108 are executed by the prediction calculation device 31.

Meanwhile, actually, the processes are executed based on the various computer programs which are stored in the CPU 3001 and the storage device 3005 of the demand type management device 30, or the processes are executed based on the various computer programs which are stored in the CPU 3101 and the storage device 3105 of the prediction calculation device 31. For convenience of explanation, description will be performed while it is assumed that various computer programs which are included in the demand type management device 30 and the prediction calculation device 31 are processing subjects.

First, the basic data extraction unit 3006 for demand pattern generation extracts the demand record information 4006A of a preset period similar to the preset consumer 10 from the demand record information 4006A as the basic data for demand pattern generation (S101).

In addition, the data generation unit 3007 for prediction value evaluation acquires the pieces of demand record information 4006A of the whole consumers 10 at a preset past evaluation target date and time from the demand record information 4006A, and generates prediction value evaluation data by performing adding up, for example, in time units of 30 minutes (S102).

Subsequently, the classification granularity adjustment processing unit 3008 trims the basic data for demand pattern generation, which are respectively extracted by the basic data extraction unit 3006 for demand pattern generation, for each of one or more combinations of the contracted demand granularity and the time granularity which are preset by the supply-demand manager 3, and prepares demand pattern generation data corresponding to the number of the above set combinations (S103).

Specifically, the classification granularity adjustment processing unit 3008 acquires the total contracted demands in such a way that, for example, the basic data extraction unit 3006 for demand pattern generation extracts data corresponding to past one year in step S101, and adds up demands corresponding to all the consumers 10 of the basic data for demand pattern generation with respect to a combination of the contracted demand granularity and the time granularity, which includes "total contracted demands" and "24 hours" as illustrated in a third row of Fig. 6, and, subsequently, trims demand pattern generation data, which includes total 365 data (hereinafter, referred to as unit data for demand pattern generation) using 24 hours as one data, by performing division on the total contracted demands in units of 24 hours. In a case where the trimming process is repeated for other combinations illustrated in Fig. 6 in the same manner, each demand pattern generation data is generated for each combination illustrated in Fig. 6.

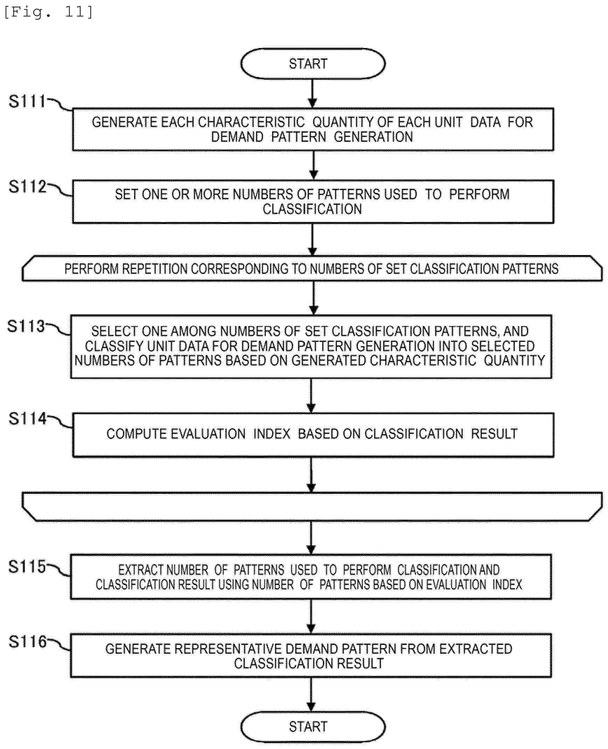

Subsequently, with respect to one demand pattern generation data generated by the classification granularity adjustment processing unit 3008, the segmentation processing unit 3009 classifies the unit data for demand pattern generation into subsets, in which the tendencies of the periodical demand variations are similar, and generates a pattern of demand (hereinafter, referred to as a demand pattern) for each representative subset based on a classification result (S104). Detailed content of a process in step S104 will be described later with reference to Fig. 11.

Subsequently, the profile processing unit 3010 generates the demand type information 3011A by extracting common attribute information among the pieces of attribute information of the consumer 10 who produces the respective demand patterns from the consumer information 4007A, the past weather information 9001A, and the past industrial dynamics information 9003A on the basis of the representative demand patterns generated by the segmentation processing unit 3009, transmits the generated demand type information 3011A to the prediction calculation device 31, and registers the demand type information 3011A in the demand type information storage unit 3011 (S105).

Specifically, the profile processing unit 3010 generates the demand type information 3011A illustrated in Figs. 7, 8, and 9 using a decision tree preparing algorithm, such as a CART, ID3, or a random forest, based on relational information between the representative demand pattern ID generated by the segmentation processing unit 3009 and the consumer ID associated with the contracted demand that belongs to the demand pattern.

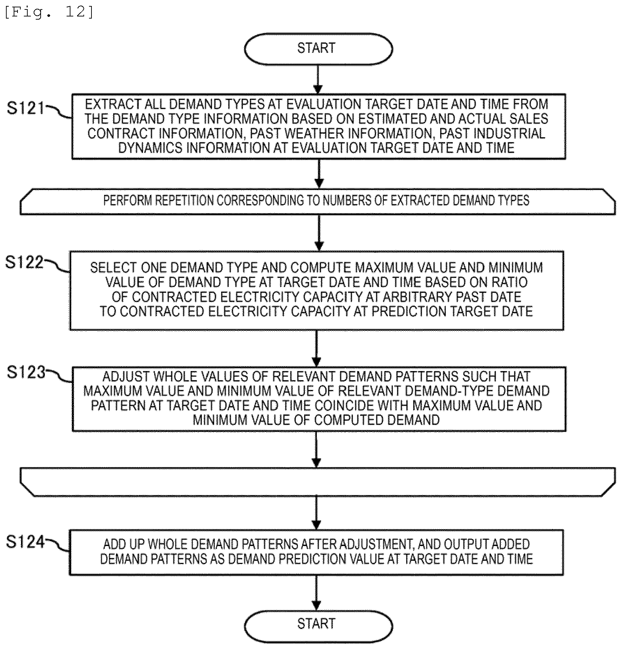

Subsequently, with respect to each of the sets of demand type information 3011A generated by the profile processing unit 3010, the evaluation prediction value computation processing unit 3106 computes a demand at the past date and time preset by the supply-demand manager 3 as the evaluation prediction value based on the demand type information 3011A, the estimated and actual sales contract information 4008A, the consumer information 4007A, the past weather information 9001A, and the past industrial dynamics information 9003A (S106). A detailed processing procedure will be described later with reference to Fig. 12.

The processes in above-described steps S104 to S106 are executed with respect to the respective demand pattern generation data generated by the classification granularity adjustment processing unit 3008.

Subsequently, the evaluation and calculation unit 3107 calculates a difference between the evaluation prediction value for each set of the demand type information 3011A generated by the evaluation prediction value computation processing unit 3106 and an evaluation record value generated by the data generation unit 3007 for prediction value evaluation, extracts a set of the demand type information 3011A in which the difference is minimized, and updates the demand type information 3011A (S107).

In the end, the final prediction value computation processing unit 3108 computes the demand prediction value at a prediction target date and time which is preset by the supply-demand manager 3 based on the demand type information 3011A, the estimated and actual sales contract information 4008A, the weather forecast information 9002A, and the industrial dynamics information 9004A which are extracted by the evaluation prediction value computation processing unit 3106, and registers the demand prediction value in the demand prediction information 4009A (S108).

A detailed processing procedure of the demand prediction value computation can be realized through the same processing procedure by inputting the estimated and actual sales contract information 4008A, the weather forecast information 9002A, and the industrial dynamics information 9004A, which are input as the past information in the processing procedure of the evaluation prediction value computation processing unit 3106 in step S106, as the estimated and actual sales contract information 4008A, the weather forecast information 9002A, and the past industrial dynamics information 9003A which are pieces of information corresponding to a future prediction target date and time.

The energy demand prediction process according to the embodiment ends by the above-described processes.

Fig. 11 illustrates detailed content of a process performed by the segmentation processing unit 3009 in step S104 of the above-described energy demand prediction process in Fig. 10. The process is executed by the segmentation processing unit 3009 and the CPU 3001 in a case where the classification granularity adjustment processing unit 3008 ends or the operation of the supply-demand manager 3 is performed.

First, the segmentation processing unit 3009 generates each characteristic quantity indicative of the periodical demand variation with respect to each unit data for demand pattern generation of the demand pattern generation data generated by the classification granularity adjustment processing unit 3008 (S111). Specifically, a frequency component is extracted by performing a Fourier transformation process after normalizing each unit data for demand pattern generation such that an average becomes 0 and the standard deviation becomes 1, and the frequency component is set to the characteristic quantity of each unit data for demand pattern generation.

Subsequently, the segmentation processing unit 3009 sets one or more pattern numbers used to perform classification on the unit data for demand pattern generation (S112). Specifically, the segmentation processing unit 3009 sets a case where the unit data for demand pattern generation is classified into two unit data, a case where the unit data for demand pattern generation is classified into three unit data, and the like.

Subsequently, the segmentation processing unit 3009 selects one of the pattern numbers used to perform classification, which are set in step S112, and classifies the unit data for demand pattern generation as many as the selected pattern numbers based on the characteristic quantity generated in step S111 (S113). Specifically, in a case where the pattern numbers used to perform classification is set to 2, a frequency component, which is the characteristic quantity of each unit data for demand pattern generation, is used as an input, and the unit data for demand pattern generation is classified into two patterns (subsets) using a clustering algorithm without a neighboring optimization teacher, such as K-means, an EM algorithm, or a spectral clustering, or a clustering algorithm without an identification surface optimization teacher such as Support Vector Machine (SVM) without a teacher, a VQ algorithm, or a Self-Organizing Maps (SOM),.

Subsequently, the segmentation processing unit 3009 computes an evaluation index value in order to evaluate the number of patterns based on the classification result (S114). Specifically, the segmentation processing unit 3009 computes the evaluation index value with respect to the number of patterns using an index, such as an Akaike information quantity reference, that measures a cohesive property inside of each classified data set and an index, such as a margin, that measures a separation property of each classified data set.

The segmentation processing unit 3009 repeats the above-described step S113 and step S114 as many as the number of patterns used to perform classification and which is set in step S112.

Subsequently, the segmentation processing unit 3009 determines the number of patterns used to perform classification based on each evaluation index value of the number of patterns computed in step S114, and extracts a result acquired through classification with the number of patterns (S115). Specifically, the segmentation processing unit 3009 determines a number, in which the index that measures the cohesive property inside each subset becomes the minimum value, and a number, in which the index value that measures the separation property between the respective subsets becomes the maximum value, as the pattern numbers used to perform classification, and extracts a result acquired through classification performed using the number of patterns from a computation result in step S113.

In the end, the segmentation processing unit 3009 generates a representative demand pattern from the extracted classification result (S116). Specifically, the segmentation processing unit 3009 computes an average value of the characteristic quantities of the respective unit data for demand pattern generation acquired through classification, and generates the representative demand pattern by performing inverse Fourier transformation on the computed average value.

In contrast, Fig. 12 illustrates detailed content of the process performed by the evaluation prediction value computation processing unit 3106 in step S106 of the above-described energy demand prediction process with reference to Fig. 10. The process is executed by the evaluation prediction value computation processing unit 3106 and the CPU 3101 in a case where the profile processing unit 3010 ends or the operation of the supply-demand manager 3 is performed.

The evaluation prediction value computation processing unit 3106 first extracts all demand types related to the evaluation target date and time from the demand type information 3011A generated by the profile processing unit 3010 based on the estimated and actual sales contract information 4008A, the past weather information 9001A, the past industrial dynamics information 9003A, and the demand record information 4006A at the evaluation target date and time which is preset by the supply-demand manager 3 (S121).

Specifically, the evaluation prediction value computation processing unit 3106 first extracts the all demand types in which the record value or the planned value of the electric power contracted capacity is not 0 at the prediction target date and time from, for example, the estimated and actual sales contract information 4008A. Furthermore, the evaluation prediction value computation processing unit 3106 extracts a demand type ID related to the target date and time by selecting a demand type, which coincides with information of weather at the target date and time and industrial dynamics information 9004A of the extracted demand types, based on the attribute information field 3011A8 of the demand type information 3011A, and acquires the demand pattern information, which is associated with the extracted demand type ID, from 3011A9.

Subsequently, the evaluation prediction value computation processing unit 3106 selects one of the extracted demand types, acquires the record value and the planned value of the sales contracted capacity of the demand type from the estimated and actual sales contract information 4008A, computes a ratio of the planned value of the contracted electric power capacity at the target date and time to the record value of the contracted electric power capacity at the arbitrary past date and time, and computes the maximum value and the minimum value of the demand on the prediction target date based on the computed ratio and the demand record information 4006A (S122).

Specifically, in a case of "April, 12, 2015" in which the selected demand type is "S1-DT001" and the prediction target date and time is the second week in 2015, the evaluation prediction value computation processing unit 3106 acquires the record value "3000 kW" as the contracted electric power capacity of the demand type. In addition, in a case where the arbitrary past date is "April, 5, 2015" corresponding to the first week in 2015, the record value "2000 kW" is acquired as the contracted electric power capacity of the demand type. Accordingly, the ratio is computed according to the following Equation.

$$3000 \text{ kW} \div 2000 \text{ kW} = 1.5 \tag{1}$$

Furthermore, the evaluation prediction value computation processing unit 3106 respectively computes the maximum value and the minimum value of a demand in "April, 5, 2015" of the demand type "S1-DT001" based on a regression equation shown in the flowing Equations (2) and (3).

$$\hat{y} = ax_1 + bx_1^2 + cx_2 + dx_2^2 \tag{2}$$

$$\hat{z} = ex_3 + fx_3^2 + gx_4 + hx_4^2 \tag{3}$$

In Equations (2) and (3), $\hat{y}$ and $\hat{z}$ respectively indicates the maximum value and the minimum value of the demand, which are explained variables, and $x_1$, $x_2$, $x_3$, and $x_4$ respectively indicate explanatory variables, for example, $x_1$ indicates a month, $x_2$ indicates an average temperature, $x_3$ indicates a record value of the minimum value of the demand on a day before, and $x_4$ indicates the lowest temperature. In addition, a, b, c, d, e, f, g, and h indicate coefficients.

Actually, the evaluation prediction value computation processing unit 3106 first extracts the maximum value and the minimum value, which are explained variables, of the demand, and the month, the average temperature, the record value of the minimum demand value of a day before, and the lowest temperature, which are the explanatory variables, from a past record of the demand type "S1-DT001" stored in the demand record information 4006A, respectively. Subsequently, the evaluation prediction value computation processing unit 3106 estimates values of the coefficients a to h through a least-squares method, respectively, based on the extracted past record. Here, the evaluation prediction value computation processing unit 3106 estimates coefficients, in which reproducibility with respect to an immediate past record value is further emphasized, by multiplying the extracted past record by a forgetting weight coefficient. Specifically, for example, in a case of the regression equation of a maximum demand value, the evaluation prediction value computation processing unit 3106 estimates the values of the coefficients a to d such that the following Equation (4) has the minimum value.

$$\sum_{n=1}^{N} w_n (y_n - \hat{y}_n)^2 \qquad (4)$$

Meanwhile, in Equation (4), N is the number of extracted past record values, $y_n$ is a record value of an extracted past maximum demand value, $w_n$ is a weight coefficient corresponding to an extracted n-th $y_n$ and $\hat{y}_n$. Specifically, the weight coefficient is a reciprocal number of the number of past days. For example, in a case of a past record value of one day before, the weight coefficient is 1/1. In a case of a past record value of two days before, the weight coefficient is 1/2. In a case of a past record value of three days before, the weight coefficient is 1/3.

Furthermore, the evaluation prediction value computation processing unit 3106 computes prediction values of the maximum value and the minimum value of the demand of a prediction target date by respectively multiplying the computed maximum value and the minimum value of the demand by the computed ratio.

Subsequently, the evaluation prediction value computation processing unit 3106 adjusts the whole demand pattern such that the prediction values of the maximum value and the minimum value of the demand at the target date, which are computed in step S122, respectively coincide with the maximum value and the minimum value of the demand pattern at the target (S123).

The evaluation prediction value computation processing unit 3106 performs the above-described steps S122 and S123 with respect to the whole demand types extracted in step S121.

Furthermore, the evaluation prediction value computation processing unit 3106 adds up the whole adjusted demand patterns for every time band, and computes the added demand patterns as the demand prediction values at the target date (S124).

With the energy demand prediction process which has been described hereinbefore, the facility manager 6 generates an operation plan of an operable electric power generation facility using the facility management device 61 based on the generated demand prediction information 4009A, and transmits the operation plan to the control device 62. The control device 62, which has received the operation plan, generates a detailed control plan of the electric power generation facility, and executes actual control.

In addition, the trade manager 5 prepares a trade plan involved in the electric power procurement with other electric service providers and trading markets using the trade management device 50, and transmits a telegram message, such as a dealing order or order cancellation, to the market operation management device 80.

With the above-described operation, the operation of the energy demand management system 1 is completed.

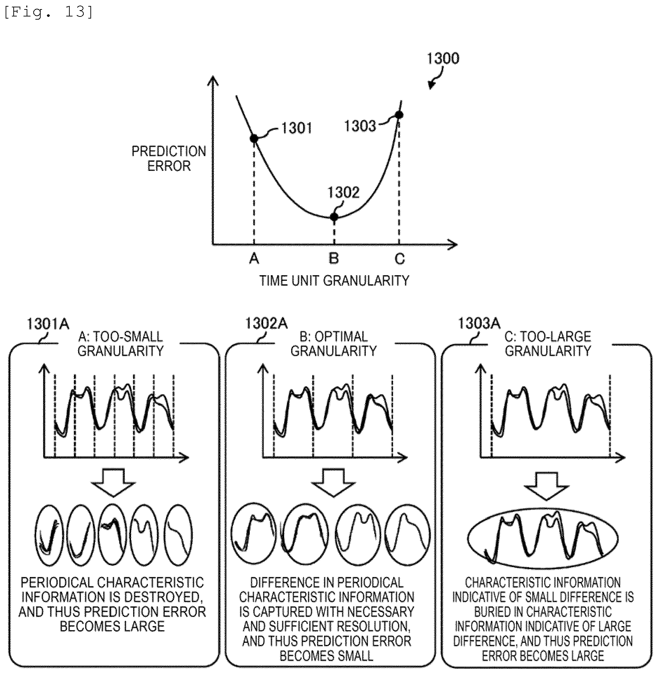

Fig. 13 is a conceptual diagram illustrating an advantage and a principle according to the embodiment. In a graph 1300 illustrated in Fig. 13, a horizontal axis indicates a time unit granularity to be divided, and a vertical axis indicates an error of the demand prediction value in a case where the demand type information 3011A generated in the time unit granularity is used.

Fig. 13 illustrates three cases, that is, a prediction error (1301) and principle explanation (1301A) in a case where a granularity acquired through division is too small, a prediction error (1302) and principle explanation (1302A) in an optimal case, and a prediction error (1303) and principle explanation (1303A) in a case where the granularity acquired through division is too large.

In the case where the classification granularity is too small, periodical characteristic information of the demand record information 4006A is destroyed, and thus the prediction error becomes large, as illustrated in 1301A. In addition, in a case where the classification granularity is too large, an information quantity indicative of large periodic characteristics is larger than an information quantity indicative of small periodic characteristics, with the result that it is difficult to capture difference in the small periodic characteristics, and thus the prediction error becomes large, as illustrated in 1303A. In the embodiment, an optimal division granularity as illustrated in 1302A is determined, and, accordingly, the error of the demand prediction value becomes minimum. Meanwhile, although Fig. 13 illustrates only the time unit granularity in order to simplify explanation, the consumer unit may be illustrated in the same manner.

(1-5) Advantage according to Embodiment

As described above, in the energy demand management system 1 according to the embodiment, the demand pattern generation data, which are used to generate the demand patterns indicative of the representative energy consumption tendencies, are respectively generated for each one or more set combinations of the contracted demand granularity and the time granularity based on the past demand record information 4006A for each measured consumer 10, one or more demand patterns indicative of the representative demand tendencies are generated in each generated demand pattern generation data set, and an attribute which commonly exists in attributes of the consumer who produces the generated demand patterns is extracted from information which may be attributes such as the consumer information 4007A, the weather forecast information 9002A, and the industrial dynamics information 9004A. Therefore, one or more demand types are generated for each demand pattern generation data set, total contracted demand prediction values at the arbitrary target date and time is computed for each demand type set using information which may be attributes, such as the estimated and actual sales contract information 4008A, the past weather information 9001A, and the past industrial dynamics information 9003A, based on the generated demand types, a demand type set in which an error between the prediction value and the actual observed value becomes minimum is extracted, and a final demand prediction value is computed using the extracted demand type set. Accordingly, according to the energy demand management system 1, it is possible to predict a demand while continuous total contracted demand characteristics change in a short time period.

(2) Second Embodiment

In a second embodiment, it is possible to estimate a maximum demand from an attribute of a demand, and thus it is possible to estimate the maximum demand in a prescribed period in advance and it is possible to perform advance application for long-term electric power procurement and an electricity transmission plan instead of causing an electricity procurement quantity to coincide with a sales quantity for each settlement time.
In the second embodiment, instead that a demand type is formed using a demand pattern and attribute information, the demand type is formed using the maximum demand, which is the maximum demand in unit time (for example, 30 minutes) of a contracted consumer, and information including an attribute in a prescribed period (for example, for one month or for one week).
Here, instead of the process of the above-described block 3009 and instead of the segmentation (division into subsets) performed on periodical characteristics, division into the subsets is performed using a clustering algorithm from a characteristic of a maximum demand value, and the demand pattern is generated. In addition, instead of the block 3108, the demand pattern is estimated from the attribute of the demand, and thus the maximum demand in the prescribed period is estimated.
The trade management device 50 makes an electric power procurement plan in the prescribed period using an estimation (prediction) value of the maximum demand, and transmits a telegram message in order to cause the market operation management device 80 to execute the plan.

(3) Another Embodiment

The energy demand management system 1 according to the embodiment is described in such a way that, in the prediction value computation process, the demand record value at the past time point is multiplied by a ratio of the contracted electric power capacity at an arbitrary past time point to the contracted electric power capacity at a prediction target time point, and thus the maximum value and the minimum value of the demand are acquired at the prediction target time point. The present invention is not limited thereto. For example, the prediction values of the maximum value and the minimum value of the demand at the prediction target time point may be multiplied by the ratio using a multiple regression model, an auto regression model, and the like. Therefore, it is possible to switch the model into a model which has higher demand prediction precision. In addition, an actually observed value may be used as the maximum value or the minimum value at the prediction target time point. In addition, the present invention is not limited to the maximum value and the minimum value, and a plurality of time values on a prediction target date may be used. Therefore, it is possible to perform the demand prediction with higher precision by reflecting the actually observed value. In addition, description is performed in which the contracted electric power capacity is used in a case where the ratio is computed. However, the present invention is not limited thereto, and the ratio may be computed based on the number of contracts. Therefore, it is possible to predict the maximum value and the minimum value of the demand according to increase and reduction in the number of contracts.
In addition, in the energy demand management system 1 according to the embodiment, the prediction values to be computed are described as a series in a 30-minute unit. However, the present invention is not limited thereto, and, for example, only the maximum value of a day, a week, a month, and a year may be computed and output. Therefore, it is possible to output the prediction values in a necessary arbitrary time section.

In addition, in the energy demand management system 1 according to the embodiment, the prediction values, which are finally computed, are described as the total contracted demand values. However, the present invention is not limited thereto, and an arbitrary contracted demand unit may be used. Therefore, it is possible to predict demands of an arbitrary specific area and only a demand type group.

In addition, in order to simplify explanation, the energy demand management system 1 according to the embodiment is described in such a way that a series of processes related to demand type generation is performed once. However, the present invention is not limited thereto, and the series of processes may be executed, for example, at prescribed intervals, such as in units of a day, in units of a week, and in units of a month, and may be executed at an arbitrary time point by the operation of the supply-demand manager 3. Therefore, it is possible to prevent deterioration in the demand prediction precision in association with a change in a scale and an aspect of sequential demands.

In addition, in order to simplify explanation, the energy demand management system 1 according to the embodiment is described as a configuration of an example in which all of combinations of the contracted demand granularity and the time granularity are defined in advance, and a combination, in which the prediction value becomes minimum, is selected among the combinations is described. However, the present invention is not limited thereto, and, for example, one combination is initially set, and, thereafter, an optimization process of searching for an optimal combination may be performed while repeating prediction value evaluation and reset of the combination. Therefore, it is possible to optimize calculation resources which are necessary for the energy demand management system 1 at a necessary and sufficient quantity.

In addition, in order to simplify explanation, the energy demand management system 1 according to the embodiment is described as a configuration of an example in which the combination of the contracted demand granularity and the time granularity is determined based on only the demand record information 4006A which is observed in the past. However, the present invention is not limited thereto and may be configured as, for example, a process on the online, that is, a series of processes related to demand type generation are executed at the same time in which the demand record is observed. Therefore, it is possible to perform adaptive demand prediction which always follows the change in the scale and the aspect of the sequential demands.

In addition, the energy demand management system 1 according to the embodiment is described as a configuration in which, after the basic data for demand pattern generation is extracted with a certain contracted demand and a time granularity, all of the data are used for subsequent processes. However, the present invention is not limited thereto, and, for example, filtering may be performed on the basic data for demand pattern generation based on arbitrary preset attribute information, such as a hot day or a type of a device, and, thereafter, the data may be used for subsequent processes. Therefore, it is possible to reflect advance information possessed by the user of the energy demand management system 1 as in cases where attribute information which will not be obviously given is pre-excluded with respect to generation of the demand pattern, only attribute information which will be clearly given is used, and the like.

In addition, the energy demand management system 1 according to the embodiment is described in such a way that the month and the average temperature, and the record value of the minimum demand value of a day before and the lowest temperature are respectively used as the explanatory variables of the regression equation, which are used in a case where the maximum value and the minimum value of the demand is computed. However, the present invention is not limited thereto, and, for example, the highest value, the lowest value, and the average value of the weather information, such as temperature, humidity, solar radiation, sunshine hours, the amount of rainfall, the amount of snowfall, the wind speed, and the atmosphere, past demand values, such as the record values of the maximum value and the minimum value of a day before, or the consumer information, such as the number of people in a room in a building of the consumer may be used as the explanatory variables. In addition, as the regression equation to be used, a linear or non-linear regression equation, such as a linear expression, a polynomial expression which is higher than a quadratic expression, Fourier series or a neural network, may be used. Furthermore, the auto regression model, such as an AR model, an ARMA model, an ARIMA model, or a VAR model, may be used. Therefore, it is possible to use the most suitable demand prediction model even in association with the change in the scale and the aspect of the sequential demands. In addition, in a case where target delay elements and the number (degree) of the delay elements are determined for the auto regression model, autocorrelation, partial autocorrelation, or both of the autocorrelation and partial autocorrelation may be calculated with respect to past data, and a weight with respect to the delay, which does not include statistical significant correlation, may be set to zero. Therefore, it is possible to prevent deterioration in the prediction precision due to delay data which does not have autocorrelation and to reduce processing loads of parameter estimation of the auto regression model.

In addition, the energy demand management system 1 according to the embodiment is described such that the regression equation and the explanatory variables are uniquely preset. However, the present invention is not limited thereto, and, for example, one of two or more types of regression models, in which a form of the regression equation, the types and the number of explanatory variables to be used are different, may be selected based on an information quantity reference such as AIC. Similarly, the maximum value and the minimum value of the demand may be computed by weighting and averaging a plurality of computation results of the regression model based on the information quantity reference. Therefore, it is possible to automatically select the most suitable demand prediction model in association with the change in the scale and the aspect of the sequential demands, and it is possible to perform adaptive prediction with respect to the change.

In addition, in the energy demand management system 1 according to the embodiment, the forgetting weight coefficient, which is used in a case where a coefficient of the regression equation that computes the maximum value and the minimum value of the demand is estimated, is described as the reciprocal number of the number of past dates. However, the present invention is not limited thereto, and, the forgetting weight coefficient may accord to, for example, an arbitrary function, such as an index function and a sigmoid function, and, for example, specification, in which a weight of the past record value of a period, during which a climate is inverse to the prediction target date, is decreased, may be performed. Therefore, it is possible to set a weight which best reproduces the change in the scale and the aspect of the sequential demands.

In addition, the energy demand management system 1 according to the embodiment is described in such a way that the demand type information, which is prepared using the decision tree preparing algorithm, such as a CART, ID3, or a random forest, is used without particularly executing a processing process or the like. However, the present invention is not limited thereto. For example, a degree of certainty may be evaluated in advance with respect to a branch, a leaf, or both of the branch and the leaf of the decision tree prepared using the decision tree preparing algorithm based on demand pattern classification precision, outlier determination with respect to an attribute value range of a branching condition of each branch, and the like, and the processing process may be substituted by one or more preset attributes, the demand pattern information prepared based on the attribute value range, and the demand pattern without being used for the branch, the leaf, or both of the branch and the leaf, which are below the degree of certainty that is a preset threshold. Therefore, it is possible to maintain a percentage of correct answers of identification of the demand pattern using the decision tree at a regular level.

In addition, in the energy demand management system 1 according to the embodiment, the number of divisions acquired in a case where the unit data for demand pattern generation is divided into subsets and the demand pattern is extracted, is described as the number, in which the index that measures the cohesive property inside each subset becomes the minimum value, and the number, in which the index value that measures the separation property between the respective subsets becomes the maximum value. However, the present invention is not limited thereto. An erroneous identification rate acquired in a case where demand pattern identification is performed using a decision tree, which is generated by the profile processing unit, may be used as an index and the number of divisions may be determined such that the erroneous identification rate is minimized. Otherwise, an error of the final prediction may be used as the index, and the number of divisions may be determined such that the error is minimized. Therefore, even in a case where available attribute information does not sufficiently exist, it is possible to perform the demand prediction at a regular level.

In addition, in the energy demand management system 1 according to the embodiment, a display unit is not described in order to simplify explanation. However, an output result of each processing unit and an intermediate result of each processing unit may be appropriately output through the output device such as the display or the printer.

Reference Signs List

    1    energy demand management system
    2    electric service provider
    3    supply-demand manager
    4    business manager
    5    trade manager
    6    facility manager
    7    system operator
    8    trading market operator
    9    public information provider
    10   consumer
    30   demand type management device
    31   prediction calculation device
    32   information input/output device
    40   sales management device
    50   trade management device
    61   facility management device
    62   control device

70    system information management device
80    market operation management device
90    public information delivery device
111   network
112   network

**Claims**

1.  An energy demand predicting system, which predicts an energy demand, comprising:

    a basic data extraction unit for demand pattern generation that extracts energy demand record information corresponding to a preset past period as basic data for demand pattern generation;
    a classification granularity adjustment processing unit that generates each of demand pattern generation data which includes one or more unit data each indicative of an energy demand for each time granularity in a combination for each of one or more preset combinations of a contracted demand granularity and the time granularity based on the extracted basic data for demand pattern generation;
    a segmentation processing unit that classifies the respective unit data included in the demand pattern generation data as a proper number of subsets based on a characteristic quantity indicative of a characteristic of an energy demand tendency for each demand pattern generation data, and extracts a demand pattern indicative of a representative energy consumption tendency for each subset;
    a profile processing unit that generates a combination of each demand pattern of the demand pattern generation data and consumer attribute information, which is common to each demand pattern, for each demand pattern generation data as a demand type of the demand pattern generation data;
    an evaluation prediction value computation processing unit that computes the energy demand at a preset past date and time as an evaluation prediction value for each demand type;
    an evaluation and calculation unit that determines the contracted demand granularity and the time granularity such that an error is minimized between an estimated value or a prediction value of the energy demand at the past date and time and an actual observed value at a relevant date and time based on the evaluation prediction value for each demand type and the energy demand record information; and
    a final prediction value computation processing unit that estimates or predicts an energy demand value at the relevant date and time based on information of the demand type according to the determined contracted demand granularity and the time granularity, information of an electricity sales plan at an arbitrary date and time, and a prediction value of the attribute information at the relevant date and time.

2.  The energy demand predicting system according to Claim 1,
    wherein the classification granularity adjustment processing unit generates each demand pattern generation data, which includes one or more unit data each indicative of the energy demand for each time granularity in the combination, for each of the preset one or more preset combinations of the contracted demand granularity and the time granularity based on the extracted basic data for demand pattern generation, extracts data which coincides with the set attribute information from the demand pattern generation data based on the preset attribute information, and generates the demand pattern generation data.

3.  The energy demand predicting system according to Claim 1,
    wherein the segmentation processing unit sets the number of subsets to a number which is equal to or larger than 2 in advance, computes a degree of similarity in the subsets and a degree of separation between the subsets in a case where the unit data is classified according to the number, and determines the number of subsets to be used to perform classification on the unit data, based on both or any one value of the degree of similarity and the degree of separation.

4.  The energy demand predicting system according to Claim 1,
    wherein the segmentation processing unit sets the number of subsets to a number which is equal to or larger than 2 in advance with respect to each demand pattern generation data, computes each error of final demand prediction for each set number of the subsets in the case where the unit data is classified according to the number, and determines the number of subsets used to perform classification on the unit data based on the error for each computed number.

5.  The energy demand predicting system according to Claim 1,

wherein the final prediction value computation processing unit extracts the unit data which belongs to each subset or the unit data which represents each subset, and estimates or predicts the energy demand value at the arbitrary date and time using any one of the extracted unit data.

6. The energy demand predicting system according to Claim 1,
   wherein the final prediction value computation processing unit computes the demand prediction value at an arbitrary time of a prediction target date by performing adjustment such that a maximum value and a minimum value of the energy demand computed from the unit data which belongs to each extracted subset relevant to the prediction target date or the unit data which represents each subset coincide with a maximum value and a minimum value of a demand on a separately predicted or observed prediction target date.

7. The energy demand predicting system according to Claim 1,
   wherein the final prediction value computation processing unit computes a maximum value and a minimum value of a demand at a prediction target date or the demand value at an arbitrary time by giving preset a weight with respect to each record data of the past period such that the weight is attached to the record data of the past period, which has a high relationship with the prediction target date or prediction target time, in estimation of the maximum value and the minimum value of the demand at the prediction target date or a coefficient of a prediction equation used to predict the demand value at the arbitrary time, identification of the prediction equation, or the estimation of the coefficient and identification of the prediction equation based on the record data in an arbitrary past period.

8. The energy demand predicting system according to Claim 1,
   wherein the attribute information includes information indicative of an attribute of each consumer, weather information, and industrial dynamics information.

9. The energy demand predicting system according to Claim 1,
   wherein the profile processing unit outputs the demand type information, record information or plan information of contract conclusion for each demand type, or both of the pieces of information.

10. The energy demand predicting system according to Claim 9,
    wherein the final prediction value computation processing unit inputs the record information and the plan information of the contract conclusion for each demand type, and transmits the computed demand prediction value to any one of a device that manages contract information, a device that manages an electric power generation facility, and a device that manages an electric power trade.

11. The energy demand predicting system according to Claim 1,
    wherein the profile processing unit computes a degree of accuracy in advance with respect to a fact that, respect to a decision tree used in generation of the demand type information, demand type information correspond as a common attribute of the demand pattern which belongs to a branch or a leaf for the branch, the leaf, or both of the branch and the leaf of the decision tree, and switches between the branch and the leaf or use or non-use of the branch and the leaf based on the computed degree of accuracy and a preset threshold.

12. An energy demand predicting method for predicting an energy demand, the method comprising:

    a first step of extracting energy demand record information corresponding to a preset past period as basic data for demand pattern generation;
    a second step of generating each of demand pattern generation data which includes one or more unit data each indicative of an energy demand for each time granularity in a combination for each of one or more preset combinations of a contracted demand granularity and the time granularity based on the extracted basic data for demand pattern generation;
    a third step of classifying the respective unit data included in the demand pattern generation data as a proper number of subsets based on a characteristic quantity indicative of a characteristic of an energy demand tendency for each demand pattern generation data, extracting a demand pattern indicative of a representative energy consumption tendency for each subset, generating a combination of each demand pattern of the demand pattern generation data and consumer attribute information, which is common to each demand pattern as a demand type of the demand pattern generation data, and computing the energy demand at a preset past date and time as an evaluation prediction value for each demand type;
    a fourth step of determining the contracted demand granularity and the time granularity such that an error is minimized between an estimated value or a prediction value of the energy demand at the past date and time and an actual observed value at a relevant date and time based on the evaluation prediction value for each demand type and the energy demand record information; and

a fifth step of estimating or predicting an energy demand value at the relevant date and time based on information of the demand type according to the determined contracted demand granularity and the time granularity, information of an electricity sales plan at an arbitrary date and time, and a prediction value of the attribute information at the relevant date and time.

[Fig. 1]

ENERGY DEMAND MANAGEMENT SYSTEM 1

PUBLIC INFORMATION PROVIDER 9
PUBLIC INFORMATION DELIVERY DEVICE
90

TRADING MARKET OPERATOR 8
MARKET OPERATION MANAGEMENT DEVICE
80

SYSTEM OPERATOR 7
SYSTEM INFORMATION MANAGEMENT DEVICE
70

ELECTRIC SERVICE PROVIDER 2

SUPPLY-DEMAND MANAGER 3
DEMAND TYPE MANAGEMENT DEVICE
30
PREDICTION CALCULATION DEVICE
31
INFORMATION INPUT/OUTPUT TERMINAL
32

111

112

6
61
62
FACILITY MANAGEMENT DEVICE
CONTROL DEVICE
FACILITY MANAGER

5
50
TRADE MANAGEMENT DEVICE
TRADE MANAGER

4
40
SALES MANAGEMENT DEVICE
BUSINESS MANAGER

CONSUMER
INFORMATION INPUT/OUTPUT TERMINAL
100
MEASUREMENT DEVICE
101
10

[Fig. 2]

ENERGY DEMAND PREDICTING SYSTEM 12

[Fig. 3]

**12**

**30 — DEMAND TYPE MANAGEMENT DEVICE**

STORAGE DEVICE

3006 — BASIC DATA EXTRACTION UNIT FOR DEMAND PATTERN GENERATION

3007 — DATA GENERATION UNIT FOR PREDICTION VALUE EVALUATION

3008 — CLASSIFICATION GRANULARITY ADJUSTMENT PROCESSING UNIT

3009 — SEGMENTATION PROCESSING UNIT

3010 — PROFILE PROCESSING UNIT

CPU — 3001
INPUT DEVICE — 3002
OUTPUT DEVICE — 3003
COMMUNICATION DEVICE
3005   3004

3011   3011A
DEMAND TYPE INFORMATION

**31 — PREDICTION CALCULATION DEVICE**

3101 — CPU
3102 — INPUT DEVICE
3103 — OUTPUT DEVICE
COMMUNICATION DEVICE
3104

3105 — STORAGE DEVICE

3106 — EVALUATION PREDICTION VALUE COMPUTATION PROCESSING UNIT

3107 — EVALUATION AND CALCULATION UNIT

3108 — FINAL PREDICTION VALUE COMPUTATION PROCESSING UNIT

3109   3109A
WEIGHT COEFFICIENT INFORMATION

112

**40 — SALES MANAGEMENT DEVICE**

STORAGE DEVICE

4006   4006A
DEMAND RECORD INFORMATION

4007   4007A
CONSUMER INFORMATION

4008   4008A
ESTIMATED AND ACTUAL SALES CONTRACT INFORMATION

4009   4009A
DEMAND PREDICTION INFORMATION

CPU — 4001
INPUT DEVICE — 4002
OUTPUT DEVICE — 4003
COMMUNICATION DEVICE
4005   4004

4010 — DATA INPUT/OUTPUT UNIT

4011 — ESTIMATED AND ACTUAL SALES CONTRACT INFORMATION GENERATION UNIT

[Fig. 4]

4007A

| CONSUMER ID | LOCATION | BUSINESS TYPE | BUILDING CATEGORY | TOTAL FLOOR AREA | MANAGEMENT COMPANY | NUMBER OF PEOPLE | CONTRACTED CAPACITY | SUPPLY START DATE | SUPPLY END DATE |
|---|---|---|---|---|---|---|---|---|---|
| C001 | OTA-KU, TOKYO | RETAIL | OFFICE | 100m2 | COMPANY A | 12 | 30 kW | 15.3.25 | UNDECIDED |
| C002 | CHIYODA-KU, TOKYO | SERVICE | OFFICE | 80m2 | COMPANY A | 24 | 25 kW | 15.4.4 | UNDECIDED |
| C003 | MINATO-KU, OSAKA | MANUFACTURING | FACTORY | 200m2 | COMPANY C | 26 | 100 kW | 15.5.1 | 15.3.31 |
| C004 | NAKA-KU, YOKOHAMA | INDIVIDUAL | DETACHED HOUSE | 120m2 | Null | 4 | 3 kW | 15.4.30 | UNDECIDED |
| ... | ... | ... | ... | ... | ... | ... | | | |

4007A1  4007A2  4007A3  4007A4  4007A5  4007A6  4007A7  4007A8  4007A9  4007A10

[Fig. 5]

4008A

| DEMAND TYPE ID | | FIRST WEEK IN 2015 | SECOND WEEK IN 2015 | THIRD WEEK IN 2015 | FOURTH WEEK IN 2015 | . . . | |
|---|---|---|---|---|---|---|---|
| S1-DT001 | PLAN | null | null | 4000 kW | 5000kW | . . . | 4008A2 |
| | RECORD | 2000 kW | 3000 kW | null | null | . . . | 4008A3 |
| S2-DT002 | PLAN | null | null | 9000 kW | 9200 kW | . . . | 4008A2 |
| | RECORD | 8800 kW | 9000 kW | null | null | . . . | 4008A3 |
| . . . | . . . | . . . | . . . | . . . | . . . | . . . | |

4008A1

[Fig. 6]

3011A

| DEMAND TYPE SET ID | CONTRACTED DEMAND GRANULARITY | TIME GRANULARITY |
|---|---|---|
| S1 | TOTAL CONTRACTED DEMAND | 8760 HOURS |
| S2 | TOTAL CONTRACTED DEMAND | 336 HOURS |
| S3 | TOTAL CONTRACTED DEMAND | 24 HOURS |
| . . . | . . . | . . . |
| SS | ONE CONTRACTED DEMAND | 24 HOURS |

3011A1　　　　3011A2　　　　3011A3

[Fig. 7]

3011A

| CONSUMER ID | DEMAND TYPE ID | | | | | | | |
|---|---|---|---|---|---|---|---|---|
| | DEMAND TYPE SET S1 | | | | ... | DEMAND TYPE SET SS | | |
| | PERIOD 1 | PERIOD 2 | ... | PERIOD T1 | | PERIOD 1 | PERIOD 2 | ... | PERIOD TS |
| C001 | S1-DT014 | S1-DT043 | ... | S1-DT022 | ... | SS-DT003 | S1-DT059 | ... | SS-DT094 |
| C002 | S1-DT021 | S1-DT021 | ... | S1-DT027 | ... | SS-DT110 | S1-DT062 | ... | SS-DT67 |
| C003 | S1-DT014 | S1-DT003 | ... | S1-DT042 | ... | SS-DT002 | S1-DT051 | ... | SS-DT022 |
| C004 | S1-DT002 | S1-DT011 | ... | S1-DT019 | ... | SS-DT016 | S1-DT011 | ... | SS-DT079 |
| ... | ... | ... | ... | ... | ... | ... | ... | ... | ... |

3011A4  3011A5  3011A5  3011A5  3011A5  3011A5  3011A5

[Fig. 8]

3011A

| DEMAND TYPE SET ID | DEMAND TYPE ID | ATTRIBUTE INFORMATION 1 | ATTRIBUTE INFORMATION 2 | ATTRIBUTE INFORMATION 3 | ... | ATTRIBUTE INFORMATION N |
|---|---|---|---|---|---|---|
| S1 | S1-DT001 | OPERATION COMPANY = COMPANY A | FLOOR AREA <= 90m2 | BUSINESS TYPE= MANUFACTURING | ... | TEMPERATURE >= 15 |
| S1 | S1-DT002 | OPERATION COMPANY = COMPANY B | NUMBER OF PEOPLE >= 50 | null | ... | null |
| ... | ... | ... | ... | ... | ... | ... |
| SS | SS-DT052 | OPERATION COMPANY = COMPANY A | FLOOR AREA >= 90m2 | BUSINESS TYPE = SERVICE | ... | TEMPERATURE < 15 |

3011A6  3011A7  3011A8  3011A8  3011A8  3011A8

[Fig. 9]

3011A

| DEMAND TYPE SET ID | DEMAND TYPE ID | TIME 1 | TIME 2 | TIME 3 | · · · |
|---|---|---|---|---|---|
| S1 | S1-DT001 | 0.66 | 0.28 | −0.088 | · · · |
| S1 | S1-DT002 | −0.29 | −0.56 | −0.82 | · · · |
| · · · | · · · | · · · | · · · | · · · | · · · |
| SS | SS-DT052 | −1.00 | −1.16 | −1.33 | · · · |

3011A6          3011A7                          3011A9

[Fig. 10]

START

S101 — BASIC DATA EXTRACTION UNIT FOR DEMAND PATTERN GENERATION
ACQUIRE PRESET CONSUMER AND RECORD INFORMATION OF PERIOD FROM DEMAND RECORD INFORMATION, AND EXTRACT BASIC DATA FOR DEMAND PATTERN GENERATION

S102 — DATA GENERATION UNIT FOR PREDICTION VALUE EVALUATION
ACQUIRE RECORD INFORMATION OF WHOLE CONSUMERS CORRESPONDING TO PRESET EVALUATION PREDICTION TARGET FROM DEMAND RECORD INFORMATION, AND GENERATE DATA FOR EVALUATION OF DEMAND PREDICTION VALUE

S103 — CLASSIFICATION GRANULARITY ADJUSTMENT PROCESSING UNIT
TRIM BASIC DATA FOR DEMAND PATTERN GENERATION WITH ONE OR MORE PRESET COMBINATIONS OF CONTRACTED DEMAND GRANULARITY AND TIME GRANULARITY, AND GENERATE DEMAND PATTERN GENERATION DATA CORRESPONDING TO NUMBER OF SET COMBINATIONS

PERFORM REPETITION CORRESPONDING TO NUMBER OF GENERATED DEMAND PATTERN GENERATION DATA

S104 — SEGMENTATION PROCESSING UNIT
EXTRACT ONE OR MORE REPRESENTATIVE DEMAND PATTERNS FROM DEMAND PATTERN GENERATION DATA

S105 — PROFILE PROCESSING UNIT
EXTRACT ATTRIBUTE INFORMATION COMMON TO EXTRACTED RESPECTIVE DEMAND PATTERNS FROM CONSUMER INFORMATION STORAGE UNIT AND PUBLIC INFORMATION DELIVERY DEVICE, AND GENERATE DEMAND TYPE

S106 — EVALUATION PREDICTION VALUE COMPUTATION PROCESSING UNIT
COMPUTE DEMAND PREDICTION VALUE USING ATTRIBUTE INFORMATION AT EVALUATION TARGET DATE AND TIME AND ESTIMATED AND ACTUAL SALES PLAN INFORMATION BASED ON GENERATED DEMAND TYPE

S107 — EVALUATION AND CALCULATION UNIT
EXTRACT DEMAND TYPE SET, IN WHICH DIFFERENCE BETWEEN COMPUTED PREDICTION VALUE AND MODEL EVALUATION DATA BECOMES MINIMUM VALUE, AND CONTRACTED DEMAND GRANULARITY AND TIME GRANULARITY OF EXTRACTED DEMAND TYPE SET

S108 — FINAL PREDICTION VALUE COMPUTATION PROCESSING UNIT
COMPUTE FINAL DEMAND PREDICTION VALUE FROM ATTRIBUTE INFORMATION AT PREDICTION TARGET DATE AND TIME AND ESTIMATED AND ACTUAL SALES CONTRACT INFORMATION BASED ON EXTRACTED DEMAND TYPE SET

END

[Fig. 11]

```
                        ╭─────────────╮
                        │    START    │
                        ╰──────┬──────╯
                               ↓
S111 ┌─────────────────────────────────────────────────────────┐
     │ GENERATE EACH CHARACTERISTIC  QUANTITY OF EACH UNIT  DATA  FOR │
     │              DEMAND  PATTERN  GENERATION                  │
     └─────────────────────────┬───────────────────────────────┘
                               ↓
S112 ┌─────────────────────────────────────────────────────────┐
     │  SET ONE OR MORE NUMBERS OF PATTERNS USED  TO  PERFORM    │
     │                  CLASSIFICATION                          │
     └─────────────────────────┬───────────────────────────────┘
                               ↓
     ┌─────────────────────────────────────────────────────────────╲
     │ PERFORM REPETITION CORRESPONDING TO NUMBERS OF SET CLASSIFICATION PATTERNS │
     └─────────────────────────┬───────────────────────────────────╱
                               ↓
S113 ┌─────────────────────────────────────────────────────────┐
     │  SELECT ONE AMONG NUMBERS OF SET CLASSIFICATION PATTERNS, AND │
     │ CLASSIFY UNIT DATA FOR DEMAND PATTERN GENERATION INTO SELECTED │
     │ NUMBERS OF PATTERNS BASED ON GENERATED CHARACTERISTIC  QUANTITY │
     └─────────────────────────┬───────────────────────────────┘
                               ↓
S114 ┌─────────────────────────────────────────────────────────┐
     │   COMPUTE EVALUATION  INDEX  BASED ON CLASSIFICATION  RESULT │
     └─────────────────────────┬───────────────────────────────┘
                               ↓
     ╱─────────────────────────────────────────────────────────╲
     └─────────────────────────┬───────────────────────────────┘
                               ↓
S115 ┌─────────────────────────────────────────────────────────┐
     │  EXTRACT NUMBER OF  PATTERNS  USED  TO  PERFORM  CLASSIFICATION AND │
     │ CLASSIFICATION RESULT USING NUMBER  OF  PATTERNS BASED ON EVALUATION  INDEX │
     └─────────────────────────┬───────────────────────────────┘
                               ↓
S116 ┌─────────────────────────────────────────────────────────┐
     │  GENERATE REPRESENTATIVE DEMAND PATTERN FROM EXTRACTED    │
     │                CLASSIFICATION RESULT                     │
     └─────────────────────────┬───────────────────────────────┘
                               ↓
                        ╭─────────────╮
                        │    START    │
                        ╰─────────────╯
```

[Fig. 12]

```
                              ┌─────────────┐
                              │    START    │
                              └──────┬──────┘
                                     ▼
        ┌──────────────────────────────────────────────────────────────┐
        │ EXTRACT ALL DEMAND TYPES AT EVALUATION TARGET DATE AND TIME    │
 S121   │ FROM THE DEMAND TYPE INFORMATION BASED ON ESTIMATED AND ACTUAL │
        │ SALES CONTRACT INFORMATION, PAST WEATHER INFORMATION, PAST     │
        │ INDUSTRIAL DYNAMICS INFORMATION AT EVALUATION TARGET DATE AND  │
        │ TIME                                                           │
        └────────────────────────────┬─────────────────────────────────┘
                                      ▼
      ╱──────────────────────────────────────────────────────────────────╲
      │ PERFORM REPETITION CORRESPONDING TO NUMBERS OF EXTRACTED DEMAND    │
      │                            TYPES                                   │
      ╲──────────────────────────────┬────────────────────────────────────╱
                                      ▼
        ┌──────────────────────────────────────────────────────────────┐
        │ SELECT ONE DEMAND TYPE AND COMPUTE MAXIMUM VALUE AND MINIMUM   │
 S122   │ VALUE OF DEMAND TYPE AT TARGET DATE AND TIME BASED ON RATIO    │
        │ OF CONTRACTED ELECTRICITY CAPACITY AT ARBITRARY PAST DATE      │
        │ TO CONTRACTED ELECTRICITY CAPACITY AT PREDICTION TARGET DATE   │
        └────────────────────────────┬─────────────────────────────────┘
                                      ▼
        ┌──────────────────────────────────────────────────────────────┐
        │ ADJUST WHOLE VALUES OF RELEVANT DEMAND PATTERNS SUCH THAT      │
 S123   │ MAXIMUM VALUE AND MINIMUM VALUE OF RELEVANT DEMAND-TYPE DEMAND │
        │ PATTERN AT TARGET DATE AND TIME COINCIDE WITH MAXIMUM VALUE    │
        │ AND MINIMUM VALUE OF COMPUTED DEMAND                           │
        └────────────────────────────┬─────────────────────────────────┘
                                      ▼
      ╱──────────────────────────────────────────────────────────────────╲
      │                                                                    │
      ╲──────────────────────────────┬────────────────────────────────────╱
                                      ▼
        ┌──────────────────────────────────────────────────────────────┐
 S124   │ ADD UP WHOLE DEMAND PATTERNS AFTER ADJUSTMENT, AND OUTPUT      │
        │ ADDED DEMAND PATTERNS AS DEMAND PREDICTION VALUE AT TARGET     │
        │ DATE AND TIME                                                  │
        └────────────────────────────┬─────────────────────────────────┘
                                     ▼
                              ┌─────────────┐
                              │    START    │
                              └─────────────┘
```

[Fig. 13]

1300

PREDICTION ERROR

1301    1303

1302

A        B        C
TIME UNIT GRANULARITY

1301A   A: TOO-SMALL GRANULARITY

PERIODICAL CHARACTERISTIC INFORMATION IS DESTROYED, AND THUS PREDICTION ERROR BECOMES LARGE

1302A   B: OPTIMAL GRANULARITY

DIFFERENCE IN PERIODICAL CHARACTERISTIC INFORMATION IS CAPTURED WITH NECESSARY AND SUFFICIENT RESOLUTION, AND THUS PREDICTION ERROR BECOMES SMALL

1303A   C: TOO-LARGE GRANULARITY

CHARACTERISTIC INFORMATION INDICATIVE OF SMALL DIFFERENCE IS BURIED IN CHARACTERISTIC INFORMATION INDICATIVE OF LARGE DIFFERENCE, AND THUS PREDICTION ERROR BECOMES LARGE

## INTERNATIONAL SEARCH REPORT

| International application No. |
| --- |
| PCT/JP2016/063696 |

**A. CLASSIFICATION OF SUBJECT MATTER**

*H02J3/00*(2006.01)i

According to International Patent Classification (IPC) or to both national classification and IPC

**B. FIELDS SEARCHED**

Minimum documentation searched (classification system followed by classification symbols)
H02J3/00, H02J5/00, H02J13/00, G06Q50/00

Documentation searched other than minimum documentation to the extent that such documents are included in the fields searched
Jitsuyo Shinan Koho          1922–1996   Jitsuyo Shinan Toroku Koho   1996–2016
Kokai Jitsuyo Shinan Koho    1971–2016   Toroku Jitsuyo Shinan Koho   1994–2016

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| A | JP 2014-164393 A  (Mitsubishi Electric Corp.), 08 September 2014 (08.09.2014), paragraphs [0004] to [0144]; fig. 1 to 15 (Family: none) | 1-12 |
| A | JP 09-285010 A  (Toshiba Corp.), 31 October 1997 (31.10.1997), paragraphs [0007] to [0094]; fig. 1 to 13 (Family: none) | 1-12 |

☐ Further documents are listed in the continuation of Box C.          ☐ See patent family annex.

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
| --- | --- |
| 24 June 2016 (24.06.16) | 05 July 2016 (05.07.16) |

| Name and mailing address of the ISA/ | Authorized officer |
| --- | --- |
| Japan Patent Office 3-4-3,Kasumigaseki,Chiyoda-ku, Tokyo 100-8915,Japan | Telephone No. |

Form PCT/ISA/210 (second sheet) (January 2015)

**EP 3 300 205 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2005328673 A
- JP 2006333687 A
- JP 7064609 A